# EUROPEAN PATENT APPLICATION

(11) **EP 3 340 325 A1**
(43) Date of publication of application: **27.06.2018**
(21) Application number: 16848469.9
(22) Date of filing: 01.09.2016
(51) Int. Cl.: H01L 41/09, B81B 3/00, B81C 1/00, G02B 26/08, G02B 26/10, H01L 41/047, H01L 41/053, H01L 41/23, H01L 41/29, H01L 41/332, G02B 27/48

(54) **PIEZOELECTRIC ELEMENT, METHOD FOR PRODUCING SAME AND PIEZOELECTRIC ACTUATOR**

(30) Priority: 24.09.2015 JP 2015186565
(71) Applicant: Mitsumi Electric Co., Ltd., Tama-Shi, Tokyo 206-8567 (JP)
(72) Inventor: AKIYAMA, Noriyuki, Tama-shi Tokyo 206-8567 (JP); NAKAMURA, Akira, Tama-shi Tokyo 206-8567 (JP)
(74) Representative: Regimbeau
(86) International application number: PCT/JP2016/075678
(87) International publication number: WO 2017/051681

(57) **Abstract**

A piezo-electric element includes a substrate; a lower electrode formed on the substrate; a piezo-electric film formed on the lower electrode; and an upper electrode formed on the piezo-electric film, wherein the upper electrode is formed on a surface on which a planarization process is performed.

## Description

### BACKGROUND OF THE INVENTION

### 1. Field of the Invention

The present invention relates to a piezo-electric element, a method of manufacturing thereof and a piezo-electric actuator.

### 2. Description of the Related Art

Conventionally, a piezo-electric element is known that uses a phenomenon to be deformed when voltage is applied to a piezo-electric film. The piezo-electric element includes, for example, a piezo-electric film and a pair of electrodes that are provided to sandwich the piezo-electric film. By applying drive voltage on the pair of electrodes, the piezo-electric film is deformed. For such a piezo-electric element, a method of manufacturing a piezo-electric film having good piezo-electric properties is disclosed (see Patent Document 1, for example).

### [Patent Document]

[Patent Document 1] Japanese Laid-open Patent Publication No. 2003-273694

Here, in the piezo-electric element, although it is important to manufacture the piezo-electric film having good piezo-electric properties, it is also important to ensure sufficient dielectric voltage. However, the above-described document does not refer to the dielectric voltage.

### SUMMARY OF THE INVENTION

The present invention is made in light of the above problems, and provides a piezo-electric element capable of improving dielectric voltage.

A piezo-electric element, includes a substrate (31); a lower electrode (32) formed on the substrate (31); a piezo-electric film (33) formed on the lower electrode (32); and an upper electrode (34) formed on the piezo-electric film (33), wherein the upper electrode (33) is formed on a surface on which a planarization process is performed.

Here, the reference numerals in the brackets are provided for facilitating understanding and just an example, and the components are not limited to the illustrated embodiments.

According to the disclosed technique, a piezo-electric element capable of improving dielectric voltage can be provided.

### BRIEF DESCRIPTION OF THE DRAWINGS

Fig. 1 is a block diagram illustrating an example of an optical scanner control apparatus of a first embodiment;
Fig. 2 is a plan view illustrating an example of an optical scanner apparatus constituting the optical scanner control apparatus;
Fig. 3 is a cross-sectional view illustrating an example of a piezo-electric element of the first embodiment;
Fig. 4 is a view (No. 1) illustrating an example of a manufacturing step of the piezo-electric element of the first embodiment;
Fig. 5 is a view (No. 2) illustrating an example of the manufacturing step of the piezo-electric element of the first embodiment;
Fig. 6 is a view (No. 3) illustrating an example of the manufacturing step of the piezo-electric element of the first embodiment;
Fig. 7 is a view (No. 4) illustrating an example of the manufacturing step of the piezo-electric element of the first embodiment;
Fig. 8 is a view for describing stress at a front end of a concave portion;
Fig. 9 is a view (No. 1) illustrating a measurement result of Weibull distribution of a breakdown electric field;
Fig. 10 is a cross-sectional view illustrating an example of a piezo-electric element of a second embodiment;
Fig. 11 is a view illustrating an example of a relationship between the thickness and the relative dielectric constant of a protection film and deformation of the piezo-electric film;
Fig. 12 is a cross-sectional image (No. 1) of a piezo-electric film on which a protection film is deposited;
Fig. 13 is a cross-sectional image (No. 2) of a piezo-electric film on which a protection film is deposited;
Fig. 14 is a view (No. 2) illustrating a measurement result of Weibull distribution of a breakdown electric field; and
Fig. 15 is a cross-sectional view illustrating an example of a piezo-electric element of an alternative example of the second embodiment.

### DETAILED DESCRIPTION OF THE PREFERRED EMBODIMENTS

Embodiments of the invention will be described herein with reference to drawings. It is to be noted that, in each of the drawings, the same components are given the same reference numerals, and explanations may not be repeated. Although an example is described in which a piezo-electric actuator including a piezo-electric element of the invention is used in an optical scanner control apparatus in the following embodiments, this is not limited so.

### (First embodiment)

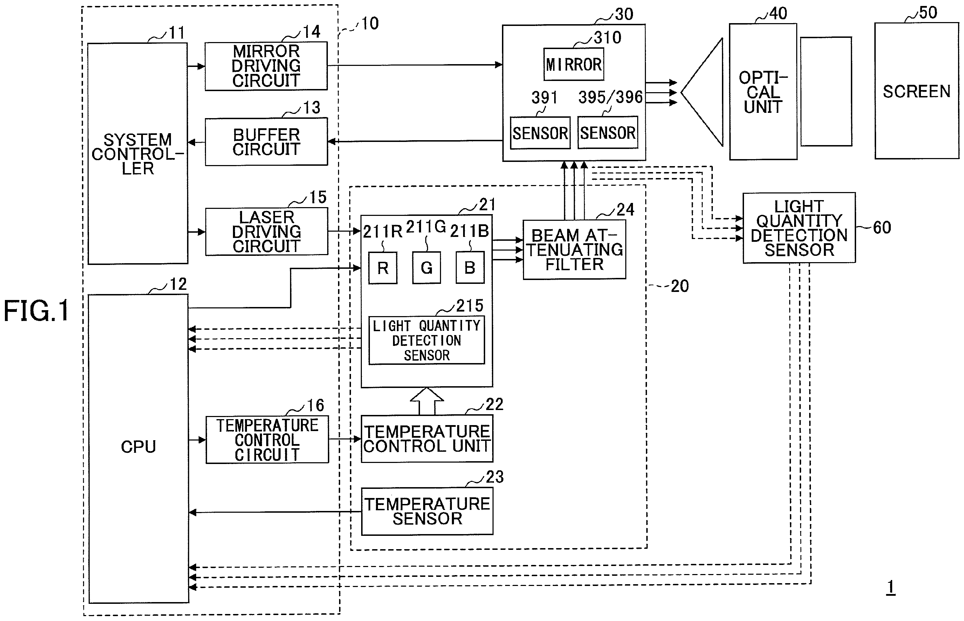

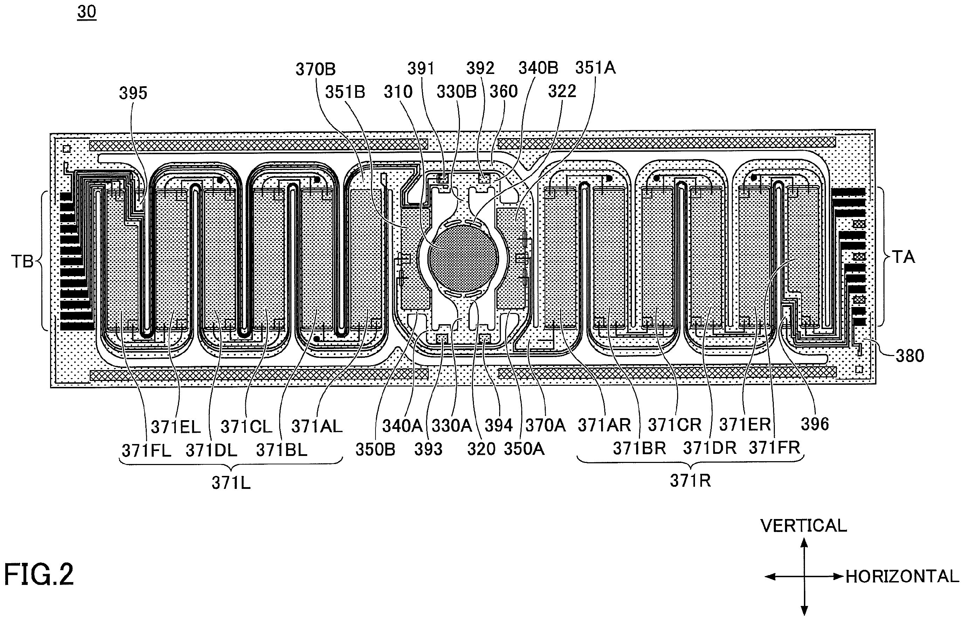

Fig. 1 is a block diagram illustrating an example of an optical scanner control apparatus of a first embodiment. Fig. 2 is a plan view illustrating an example of an optical scanner apparatus that constitutes the optical scanner control apparatus.

### (Schematic structure of optical scanner control apparatus)

First, with reference to Fig. 1 and Fig. 2, a schematic structure of an optical scanner control apparatus 1 is described. The optical scanner control apparatus 1 includes, as main constituents, a circuit unit 10, a light source unit 20, an optical scanner apparatus 30, an optical unit 40, a screen 50 and a light quantity detection sensor 60. The optical scanner control apparatus 1 is, for example, a laser scanning projector.

The circuit unit 10 is a portion that controls the light source unit 20 and the optical scanner apparatus 30, and may be constituted by, for example, a system controller 11, a CPU (Central Processing Unit) 12, various driving circuits and the like.

The light source unit 20 includes an LD module 21, a temperature control unit 22, a temperature sensor 23 and a beam attenuating filter 24.

The LD module 21 includes lasers 211R, 211G and 211B each of whose output light quantity is changed in accordance with a current value, a light quantity detection sensor 215 that monitors the latest light quantity of each of the lasers 211R, 211G and 211B, and the like. The laser 211R may be a red semiconductor laser and may output light with wavelength λR (640 nm, for example), for example. The laser 211G may be a green semiconductor laser and may output light with wavelength λG (530 nm, for example), for example. The laser 211B may be a blue semiconductor laser and may output light with wavelength λB (445 nm, for example), for example. As the light quantity detection sensor 215, for example, a photodiode or the like may be used. The light quantity detection sensor 215 may be placed at an appropriate position at which the light quantity before passing the beam attenuating filter 24 can be detected.

The temperature control unit 22 may control the lasers 211R, 211G and 211B to be predetermined temperatures, respectively. The temperature sensor 23 may detect temperature of each of the lasers 211R, 211G and 211B. As the temperature control unit 22, for example, a Peltier element may be used. As the temperature sensor 23, for example, a thermistor may be used.

The beam attenuating filter 24 is placed at a preceding stage of a mirror 310, and light (synthesized light) output from the lasers 211R, 211G and 211B is input. The beam attenuating filter 24 has a function to adjust brightness on the screen 50. As the beam attenuating filter 24, an ND (Neutral Density) filter, a liquid crystal device (liquid crystal element), a polarizing filter or the like may be used. The beam attenuating filter 24 is, for example, inserted to be inclined with respect to an optical axis of incident light, and light that does not pass (attenuated light) is absorbed or reflected by the beam attenuating filter 24.

The optical scanner apparatus 30 is, for example, a MEMS (Micro Electro Mechanical System) that drives the mirror 310 by a piezo-electric element. The mirror 310 functions as scanning means that forms an image on the screen 50 by reflecting light (synthesized light) output from the lasers 211R, 211G and 211B, and two-dimensionally scanning the incident light in a horizontal direction and in a vertical direction in accordance with an image signal.

Specifically, as illustrated in Fig. 2, the optical scanner apparatus 30 includes the mirror 310, a mirror support portion 320, torsion beams 330A and 330B, connecting beams 340A and 340B, driving beams 350A and 350B, a movable frame 360, driving beams 370A and 370B and a fixed frame 380. The driving beams 350A and 350B respectively include driving sources 351A and 351B. The driving beams 370A and 370B respectively include driving sources 371R and 371L. The driving beams 350A and 350B and the driving beams 370A and 370B function as actuators that scan laser light by oscillating the mirror 310 in upper-lower or left-right directions.

The mirror support portion 320 is provided with slits 322 along a circumference of the mirror 310. By providing the slits 322, the mirror support portion 320 can be lightened and stress that is generated when transmitting torsion by the torsion beams 330A and 330B to the mirror 310 can be reduced.

In the optical scanner apparatus 30, the mirror 310 is supported at a front surface of the mirror support portion 320, and the mirror support portion 320 is connected to end portions of the torsion beams 330A and 330B that are provided at both sides of the mirror support portion 320. The torsion beams 330A and 330B form an oscillating axis, and supports the mirror support portion 320 from both sides in an axial direction by extending in the axial direction. When the torsion beams 330A and 330B are distorted, the mirror 310 supported by the mirror support portion 320 is oscillated so that reflected light irradiated on the mirror 310 is scanned. The torsion beams 330A and 330B are connected to be supported by the connecting beams 340A and 340B, and further connected to the driving beams 350A and 350B, respectively.

The driving beams 350A and 350B, the connecting beams 340A and 340B, the torsion beams 330A and 330B, the mirror support portion 320 and the mirror 310 are surrounded by the movable frame 360. One side of each of the driving beams 350A and 350B is supported by the movable frame 360. The other side of the driving beam 350A extends an inner side to be connected to the connecting beams 340A and 340B. The other side of the driving beam 350B similarly extends an inner side to be connected to the connecting beams 340A and 340B.

The driving beams 350A and 350B are provided as a pair in a direction perpendicular to the torsion beams 330A and 330B such that to interpose the mirror 310 and the mirror support portion 320 therebetween. The driving sources 351A and 351B are provided at front surfaces of the driving beams 350A and 350B, respectively. The driving sources 351A and 351B are piezo-electric elements each having a structure in which a lower electrode, a piezo-electric film (a PZT film or the like) and an upper electrode are stacked in this order on the surfaces of the driving beams 350A and 350B, respectively. Each of the driving sources 351A and 351B extends or shrinks in accordance with polar of the drive voltage that is applied to the upper electrode and the lower electrode.

Thus, by alternately applying drive voltages of different phases to the driving beam 350A and the driving beam 350B, respectively, the driving beam 350A and the driving beam 350B alternately oscillate opposite directions (upper or lower) at left-right sides of the mirror 310. With this, the mirror 310 can be oscillated around an axis while having the torsion beams 330A and 330B as an oscillating axis or a rotation axis. Hereinafter, a direction in which the mirror 310 is oscillated around the axis of the torsion beams 330A and 330B is referred to as a "horizontal direction". For example, a resonance frequency is used for horizontal driving by the driving beams 350A and 350B, and it is possible to drive the mirror 310 to be oscillated at a high speed.

As such, the driving beams 350A and 350B are horizontal driving beams including horizontal driving sources 351A and 351B that oscillate the mirror 310 in the horizontal direction, respectively.

One end of each of the driving beams 370A and 370B is connected to an outer side of the movable frame 360. The driving beams 370A and 370B are connected to the movable frame 360 at positions that are point symmetry with respect to the mirror 310 as a center, and are provided as a pair to interpose the movable frame 360 therebetween from left-right sides, respectively. The driving beam 370A includes multiple beams each extending in parallel with respect to the driving beam 350A where adjacent beams are connected with each other at respective end portions to form a zig-zag shape as a whole. The other end of the driving beam 370A is connected to an inner side of the fixed frame 380. The driving beam 370B includes, similarly, multiple beams each extending in parallel with respect to the driving beam 350B where adjacent beams are connected with each other at respective end portions to form a zig-zag shape as a whole. The other end of the driving beam 370B is connected to an inner side of the fixed frame 380.

The driving sources 371R and 371L are formed on front surfaces of each of the rectangular beams, not including curbed portions, of the driving beams 370A and 370B, respectively. The driving sources 371R and 371L are piezo-electric elements each having a structure in which a lower electrode, a piezo-electric film and an upper electrode are stacked in this order on the surfaces of the driving beams 370A and 370B, respectively.

In the driving beams 370A and 370B, by applying driving voltages of different polarities to the adjacent driving sources 371R and 371L of the adjacent rectangular beams, the adjacent rectangular beams are warped in the opposite directions in the upper and lower direction. Thus, the accumulated movement of the rectangular beams in the upper and lower direction is transmitted to the movable frame 360. The driving beams 370A and 370B oscillate the mirror 310 in the vertical direction, which is perpendicular to the horizontal direction by this operation. For example, for the vertical driving by the driving beams 370A and 370B, a non-resonance frequency may be used.

For example, the driving source 371R includes driving sources 371AR, 371BR, 371CR, 371DR, 371ER and 371FR that are aligned rightward from a movable frame 360 side. The driving source 371L includes driving sources 371AL, 371BL, 371CL, 371DL, 371EL and 371FL that are aligned leftward from a movable frame 360 side. In such a case, by driving the driving sources 371AR, 371BL, 371CR, 371DL, 371ER and 371FL by the same waveform, and the driving sources 371BR, 371AL, 371DR, 371CL, 371FR and 371EL by the waveform with different phase from that for the driving sources 371AR, 371BL, 371CR, 371DL, 371ER and 371FL, the mirror 310 can be oscillated in the vertical direction.

As such, the driving beams 370A and 370B are vertical driving beams including vertical driving sources 371R and 371L that oscillate the mirror 310 in the vertical direction, respectively.

Drive interconnects that apply drive voltage to the upper electrode and the lower electrode of the driving source 351A are connected to predetermined terminals of a group of terminals TA provided at the fixed frame 380. Drive interconnects that apply drive voltage to the upper electrode and the lower electrode of the driving source 351B are connected to predetermined terminals of a group of terminals TB provided at the fixed frame 380. Drive interconnects that apply drive voltage to the upper electrode and the lower electrode of the driving source 371R are connected to predetermined terminals of the group of terminals TA provided at the fixed frame 380. Drive interconnects that apply drive voltage to the upper electrode and the lower electrode of the driving source 371L are connected to predetermined terminals of the group of terminals TB provided at the fixed frame 380.

The optical scanner apparatus 30 includes a horizontal displacement sensor 391 that detects inclination (oscillation angle in the horizontal direction) of the mirror 310 in the horizontal direction when the drive voltage is applied to the driving sources 351A and 351B and the mirror 310 is oscillated in the horizontal direction.

The optical scanner apparatus 30 includes vertical displacement sensors 395 and 396 that detect inclination (oscillation angle in the vertical direction) of the mirror 310 in the vertical direction when the voltage is applied to the driving sources 371R and 371L and the mirror 310 is oscillated in the vertical direction.

Referring back to Fig. 1, the optical unit 40 is an optical system that projects light scanned by the optical scanner apparatus 30 on the screen 50. The light input in the optical unit 40 from the optical scanner apparatus 30 forms an image on the screen 50, and an image corresponding to the image signal is displayed on the screen 50.

The screen 50 includes, for example, a micro-lens array for removing noises of an image that are seen as particles called speckles. In such a case, each of the micro-lenses that compose the micro-lens array corresponds to a pixel of a display, and it is preferable that an irradiated laser beam is equal to a size of the micro-lens or less than the size of the micro-lens.

The light quantity detection sensor 60 may be placed at an appropriate position at which the quantity of the light that passes the beam attenuating filter 24 can be detected. The light quantity detection sensor 60 is capable of independently detecting the light quantity of each of the lasers 211R, 211G and 211B after passing the beam attenuating filter 24. As the light quantity detection sensor 60, for example, one or a plurality of photodiodes or the like may be used.

### (Schematic operation of optical scanner control apparatus)

Next, an operation of the optical scanner control apparatus 1 is schematically described. The system controller 11 may control an oscillating angle of the mirror 310, for example. The system controller 11 may monitor inclination of the mirror 310 in the horizontal direction and the vertical direction obtained at the horizontal displacement sensor 391 and the vertical displacement sensors 395 and 396 via a buffer circuit 13, and supply an angle control signal to a mirror driving circuit 14, for example. Then, the mirror driving circuit 14 may supply predetermined drive signals to the driving beams 351 and 352 and the driving beams 371 and 372 based on the angle control signal from the system controller 11 to drive (scan) the mirror 310 at a predetermined angle.

Further, the system controller 11 may supply, for example, a digital image signal to a laser driving circuit 15. Then, the laser driving circuit 15 may supplies predetermined current to the lasers 211R, 211G and 211B based on the image signal from the system controller 11. With this, the lasers 211R, 211G and 211B emit lights of red, green and blue that are modulated in accordance with the image signal, respectively, and by synthesizing these lights, a color image can be formed.

The CPU 12 may monitor primitive light quantity output from each of the lasers 211R, 211G and 211B by the output of the light quantity detection sensor 215, and supply a light quantity control signal to the LD module 21, for example. Each of the lasers 211R, 211G and 211B is current controlled to output predetermined light quantity based on the light quantity control signal from the CPU 12.

Here, the light quantity detection sensor 215 may include three sensors each independently detecting the light quantity of the each of the lights output from the lasers 211R, 211G and 211B. Alternatively, the light quantity detection sensor 215 may be constituted by a single sensor. In such a case, it is possible to control the light quantity of the light out from each of the lasers 211R, 211G and 211B by causing the lasers 211R, 211G and 211B to emit light in order, and detecting by the single sensor.

Further, the CPU 12 may monitor temperatures of the lasers 211R, 211G and 211B by monitoring the output of the temperature sensor 23, and supply a temperature control signal to a temperature control circuit 16. Then, the temperature control circuit 16 supplies predetermined current to the temperature control unit 22 based on the temperature control signal from the CPU 12. With this, the temperature control unit 22 is heated or cooled, and each of the lasers is controlled to be predetermined temperature.

The light quantity detection sensor 60 detects light quantity of light after passing through the beam attenuating filter 24. As described above, the light quantity detection sensor 215 for adjusting the light quantity of each of the lasers is mounted in the LD module 21, and the light quantity detection sensor 215 detects primitive output light quantity of each of the lasers 211R, 211G and 211B (before passing through the beam attenuating filter 24). However, as an image that is actually displayed in the optical scanner control apparatus 1 is formed by light imaged on the screen 50, there may be a case that the light is not appropriately adjusted by an adjustment based on the primitive laser light quantity.

For example, as the beam attenuating filter 24 is provided on an optical path, depending on characteristics of the beam attenuating filter 24, there may be a case that an expected attenuating ratio cannot be obtained, and the light quantity after passing the beam attenuating filter 24 does not become an expected value. Further, when attenuating ratios of R / G / B of the beam attenuating filter 24 are dispersed, balance after passing through the beam attenuating filter 24 may not be retained. Further, there may be a case that characteristics of the optical scanner apparatus 30 are changed due to temperature or aged deterioration. Such problems cannot be dissolved even if the light quantity before passing through the optical scanner apparatus 30 is precisely controlled by the light quantity detection sensor 215.

Thus, in the optical scanner control apparatus 1, as light quantity detection means for detecting the light quantity after passing through the beam attenuating filter 24, a light quantity detection sensor 60, is provided. A detection result of the light quantity detection sensor 60 is input in the CPU 12, and the CPU 12 may supply a light quantity control signal for controlling a current value of each of the lasers to the LD module 21 based on the light quantity detected by the light quantity detection sensor 60.

With this, light quantity of the laser light including variation of the characteristics of the beam attenuating filter 24 can be detected. Thus, the light quantity can be accurately controlled so as to correspond to an image that is actually displayed on the screen 50. Here, the light quantity detection sensor 60 may independently detect the light quantity of each of the lasers 211R, 211G and 211B, and the CPU 12 may control the current value of each of the lasers based on the respective light quantity detected by the light quantity detection sensor 60.

### (Structure of piezo-electric element)

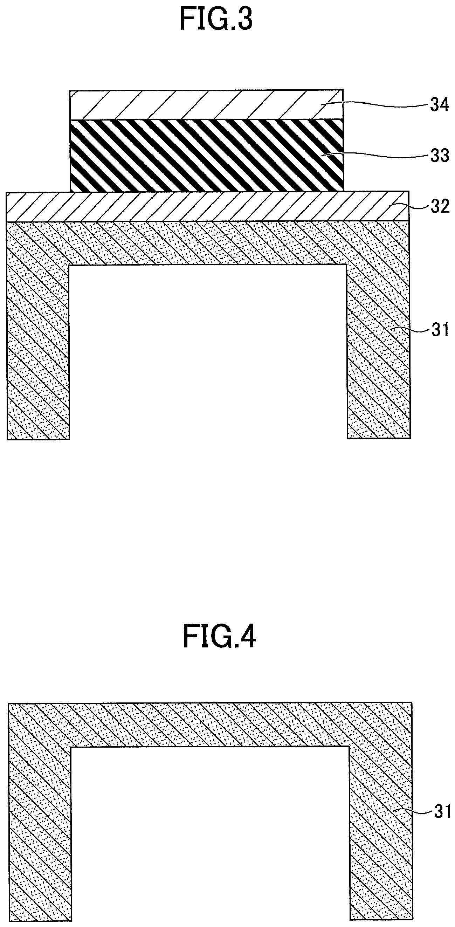

Here, a structure of the piezo-electric element that constitutes each of the driving sources 351A and 351B and the driving sources 371R and 371L is described. Fig. 3 is a cross-sectional view illustrating an example of the piezo-electric element of the first embodiment.

As illustrated in Fig. 3, the piezo-electric element of the first embodiment has a structure in which a lower electrode 32, a piezo-electric film 33 and an upper electrode 34 are stacked in this order on a substrate 31 having a diaphragm structure that constitutes each of the driving beams 350A and 350B and the driving beams 370A and 370B.

As a material of the substrate 31, for example, an SOI (Silicon on Insulator) may be used. In such a case, for example, a diaphragm portion may be formed by a silicon active layer, and a support portion that supports the diaphragm portion may be formed by a buried oxide film and a silicon substrate at a back surface. As a material of the substrate 31 other than SOI, for example, silicon, alumina, sapphire, yttria-stabilized zirconia, stainless or the like may be used.

As each of the lower electrode 32 and the upper electrode 34, for example, a stacked film in which LaNiO₃ / Pt / LaNiO₃ are stacked in this order may be used. In such a case, the thickness of each LaNiO₃ may be, for example, approximately 10 to 100 nm. The thickness of Pt may be, for example, approximately 50 to 200 nm. As a structure of each of the lower electrode 32 and the upper electrode 34 other than this, for example, a metal such as Au or Pt, a metal oxide such as LaNiO₃, SrRuO₃ or IrO₃, or a combination thereof may be used.

As the piezo-electric film 33, for example, Pb(Zr, Ti)O₃ (lead zirconate titanate: a so-called PZT), which is a lead-based material may be used. In such a case, an additive such as La₂O₃, Nd₂O₃, Nd₂O₅, Ta₂O₅, or WO₃ may be added to PZT. Alternatively, as the piezo-electric film 33, for example, a non-lead BaTiO₃-based, KNbO₃-NaNbO₃-LiNbO₃-based, (Bi_{1/2}Na_{1/2}) TiO₃-based piezo-electric ceramic or the like, which is a non-lead based material may be used. Here, a planarization process is performed on an upper surface (a surface that contacts the upper electrode 34) of the piezo-electric film 33.

### (Method of manufacturing piezo-electric element)

Here, a method of manufacturing the piezo-electric element is described by exemplifying a case in which an SOI is used as the substrate 31, LaNiO₃ / Pt / LaNiO₃ is used for each of the lower electrode 32 and the upper electrode 34 and PZT is used as the piezo-electric film 33.

First, in a step illustrated in Fig. 4, SOI with a thickness of approximately 500 µm is prepared, and SiO₂ (not illustrated in the drawings) with a thickness of approximately 500 nm as an insulation film is formed at an upper surface (at a silicon active layer side) of the SOI by thermal oxidation. Thereafter, the substrate 31 is manufactured by processing a back surface of the SOI by anisotropic etching or the like.

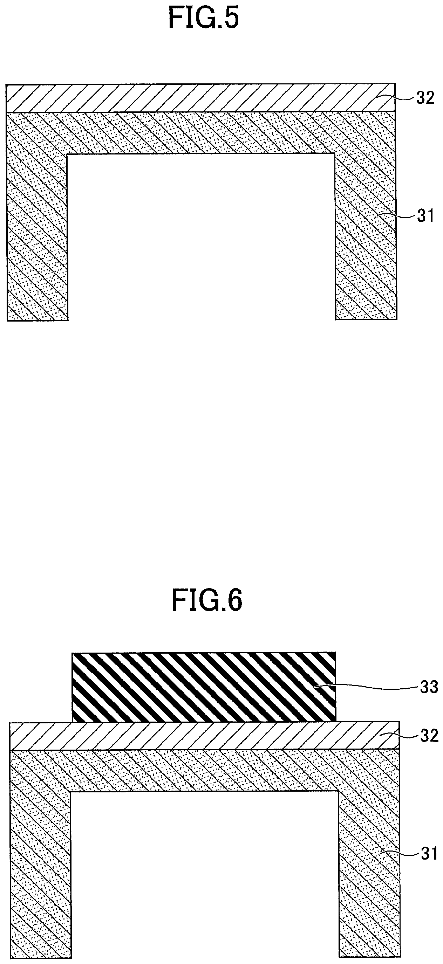

Next, in a step illustrated in Fig. 5, by stacking LaNiO₃ / Pt / LaNiO₃ in this order on an upper surface of the substrate 31 by a PVD (Physical Vapor Deposition) method or the like, for example, the lower electrode 32 is formed.

Next, in a step illustrated in Fig. 6, a thin film of PZT with a thickness of approximately 2 µm is formed on an upper surface of the lower electrode 32 by a CSD (Chemical Solution Deposition) method or the like, for example. Then, by baking the thin film of PZT at predetermined temperature, the crystallized piezo-electric film 33 is manufactured.

Thereafter, a planarization process is performed on an upper surface of the piezo-electric film 33. Specifically, the upper surface of the piezo-electric film 33 is etched for approximately 50 nm to flatten (reduce the roughness) the upper surface of the piezo-electric film 33. It is desirable that an arithmetic average roughness Ra (measured area: 10 µm□) of the upper surface of the piezo-electric film 33 after etching, measured by an atomic force microscope (AFM), is less than or equal to 1.3 nm, and more desirably, less than or equal to 1.0 nm.

The planarization process may be performed by, for example, RIE (Reactive Ion Etching), IBE (Ion Beam Etching), GCIB (Gas Cluster Ion Beam) or the like. Here, GCIB is most desirable as the method of the planarization process. This is because damage to the piezo-electric film 33 is small, and also roughness of the upper surface of the piezo-electric film 33 can be furthermore reduced. It is desirable that a gas species used in GCIB can chemically react with an object to be etched, and when the piezo-electric film 33 is PZT, SF₆, C₄F₈ or the like may be used.

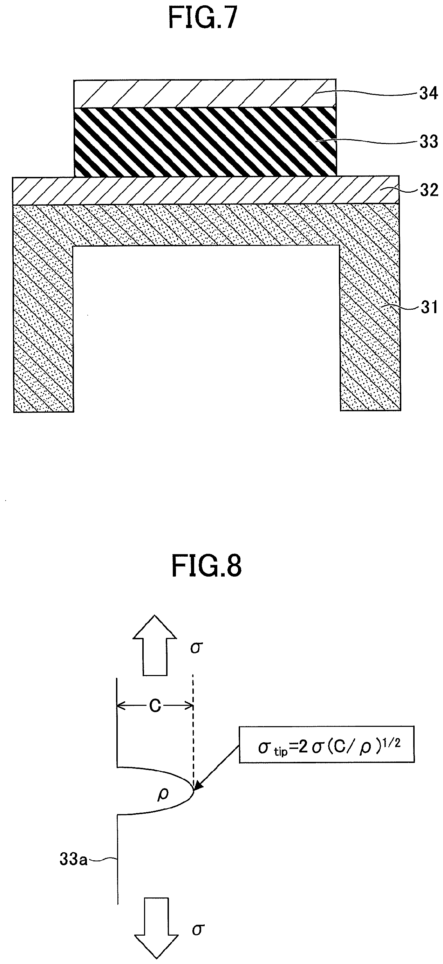

Next, in a step illustrated in Fig. 7, by stacking LaNiO₃ / Pt / LaNiO₃ in this order on an upper surface of the piezo-electric film 33 on which the planarization process is performed by a PVD method or the like, for example, the upper electrode 34 is formed. By the above described steps, the piezo-electric element illustrated in Fig. 3 is manufactured.

As such, the planarization process is performed on the upper surface of the piezo-electric film 33 in this embodiment. This is for improving dielectric voltage of the piezo-electric film 33. This is described with reference to Fig. 8.

A piezo-electric film is generally manufactured by a deposition method such as sputtering or a sol-gel method. In order to obtain high piezo-electric characteristics, it is necessary to crystallize, and an outer most surface is at a state in which crystal grains are aggregated. Thus, irregularity (concavo-convex portion) is inevitably generated between crystal grains. When the upper electrode is formed on the surface with irregularity, an electrode material cannot enter a space between the concavo-convex portions, and fine concave portions or voids are formed. In such a case, stress that is generated when the piezo-electric film is deformed (when voltage is applied) concentrates on a front end of the concave portion, crack is generated at the front end of the concave portion, and breakdown occurs when the crack is expanded.

As illustrated in Fig. 8, stress at a front end of a concave portion with a length of "C" and with a radius of curvature "ρ" is expressed as σₜᵢₚ = 2σ (C / ρ)^{1/2}. Here, "33a" is an upper surface of the piezo-electric film and "σ" is stress when the piezo-electric film is deformed. For example, when C = 10 nm and ρ = 0.4 nm, σₜᵢₚ = 10σ. This means that the stress "σₜᵢₚ" at the front end of the concave portion becomes 10 times of the stress "σ" when the piezo-electric film is deformed. As such, the stress generated when the piezo-electric film is deformed is concentrated on the front end portion of the concave portion at which a radius of curvature is minimum. Thus, even for a fine concave portion, that becomes a cause of breakdown (lowering of dielectric voltage). Thus, in this embodiment, by performing the planarization process on the upper surface of the piezo-electric film 33, the concave portion is furthermore finely made.

### (Study on dielectric voltage)

A plurality of samples each having the structure of Fig. 3 were manufactured in accordance with the method of manufacturing the piezo-electric element illustrated in Fig. 4 to Fig. 7, and dielectric voltage was studied. Contents for each of the samples are as illustrated in Table 1. In example 1 and comparative example 1, a planarization process by GCIB was performed by different gas species, and for comparative examples 2 to 4, the planarization process was not performed. Here, the thickness of the piezo-electric film 33 (PZT) of each of the samples was 2.0 µm and the electrode diameter of each of the lower electrode 32 and the upper electrode 34 was 1 mmϕ.

**[Table 1]**

| SAMPLE | MATERIAL OF PIEZO-ELECTRIC FILM | BAKING TEMPERATURE OF PIEZO-ELECTRIC FILM (°C) | GAS |
|---|---|---|---|
| EXAMPLE 1 | PZT | 650 | SF₆+He |
| COMPARATIVE EXAMPLE 1 | PZT | 650 | Ar |
| COMPARATIVE EXAMPLE 2 | PZT | 700 | - |
| COMPARATIVE EXAMPLE 3 | PZT | 700 | - |
| COMPARATIVE EXAMPLE 4 | PZT | 650 | - |

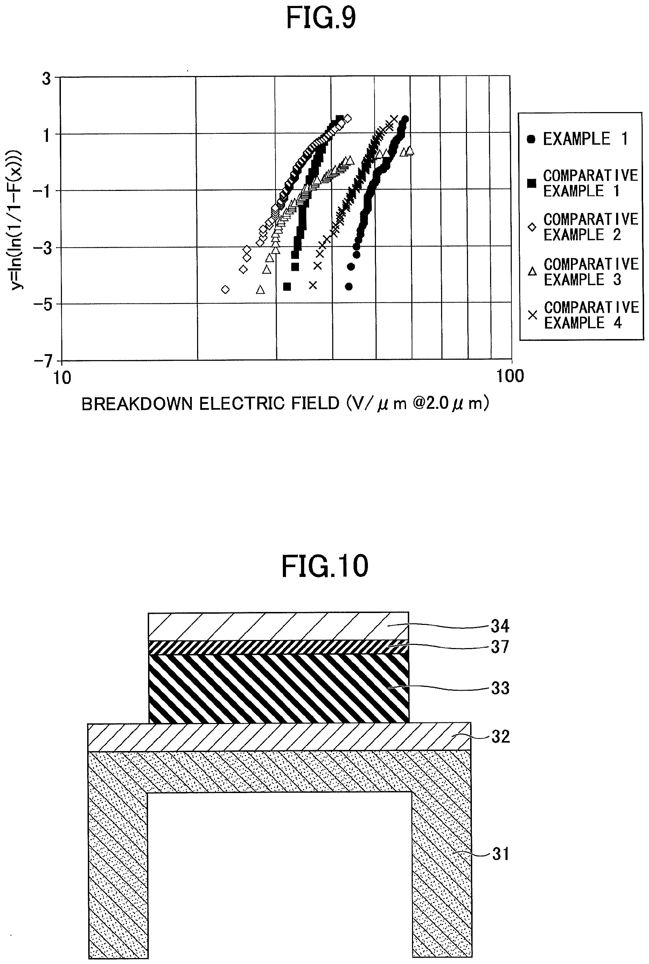

Next, direct-current voltage was applied between the lower electrode 32 and the upper electrode 34 of each of the manufactured samples, and dielectric voltage was measured. Weibull distribution of the breakdown electric field is illustrated in Fig. 9. Further, an average value Ave, a maximum value MAX, a minimum value MIN, dispersion MAX-MIN of the dielectric voltage are illustrated in Table 2.

**[Table 2]**

| SAMPLE | DIELECTRIC VOLTAGE (V/ *µ* m) | | | |
|---|---|---|---|---|
| | Ave. | MAX | MIN | MAX-MIN |
| EXAMPLE 1 | 51.35 | 58.42 | 43.48 | 14.95 |
| COMPARATIVE EXAMPLE 1 | 36.45 | 41.67 | 31.70 | 9.96 |
| COMPARATIVE EXAMPLE 2 | 33.49 | 43.48 | 23.10 | 20.38 |
| COMPARATIVE EXAMPLE 3 | 38.59 | 59.78 | 27.63 | 32.16 |
| COMPARATIVE EXAMPLE 4 | 46.47 | 55.25 | 36.23 | 19.02 |

As illustrated in Fig. 9, example 1 is shifted most in a rightward direction, and dielectric voltage is improved most. Although designed drive voltage is approximately 20 V, it is preferable that Weibull distribution of Fig. 9 is shifted rightward because margin of dielectric voltage can be largely retained.

Further, as illustrated in Table 2, an average value Ave of the dielectric voltage of example 1 is 51.35 (V / µm), which is larger than those of comparative examples 1 to 4. Further, a maximum value MAX is 58.42 (V / µm), a minimum value MIN is 43.48 (V / µm) and dispersion MAX-MIN is 14.95 (V / µm), which is the second minimum.

For comparative example 1, the gas species of GCIB was Ar and, and etching residues of PZT evenly remain on the entire surface. Thus, it can be considered that the average value of the dielectric voltage becomes lower and the dispersion becomes extremely small. For each of comparative examples 2 to 4, as the planarization process was not performed on the upper surface of the piezo-electric film 33, it can be considered that the average value of dielectric voltage became low due to the above described stress concentration (see Fig. 8).

As such, in the first embodiment, the planarization process is performed on the upper surface of the piezo-electric film 33, and the surface roughness of the upper surface of the piezo-electric film 33 that contacts the upper electrode 34 is reduced. With this, a starting point on which stress is concentrated when the piezo-electric film 33 is deformed can be removed, and dielectric voltage of the piezo-electric film 33 can be improved. Further, it is preferable that the planarization process is performed by GCIB, and it is important to select appropriate gas species in such a case.

### (Second embodiment)

In a second embodiment, an example of a piezo-electric element including a protection film is described. In the second embodiment, explanations of the components that are the same as those already described may not be repeated.

Fig. 10 is a cross-sectional view illustrating an example of the piezo-electric element of the second embodiment. As illustrated in Fig. 10, the piezo-electric element of the second embodiment is different from the piezo-electric element of the first embodiment (see Fig. 3) in that a protection film 37 is provided between the piezo-electric film 33 and the upper electrode 34.

As a material of the protection film 37, for example, TiOₓ, SrTiOₓ, (Ba, Sr)TiO₃, BaO-R₂O₃-TiO₂, Ba-PbO-Nd₂O₃-TiO₂, CaTiO₃, (Ca, Li, Sm)TiO₃, Ag(Nb, Ta)O₃ or the like may be used. As a method of depositing the protection film 37, it is preferable to use an Atomic Layer Deposition method (ALD method) that has high embedding properties for concavo-convex portions at a surface.

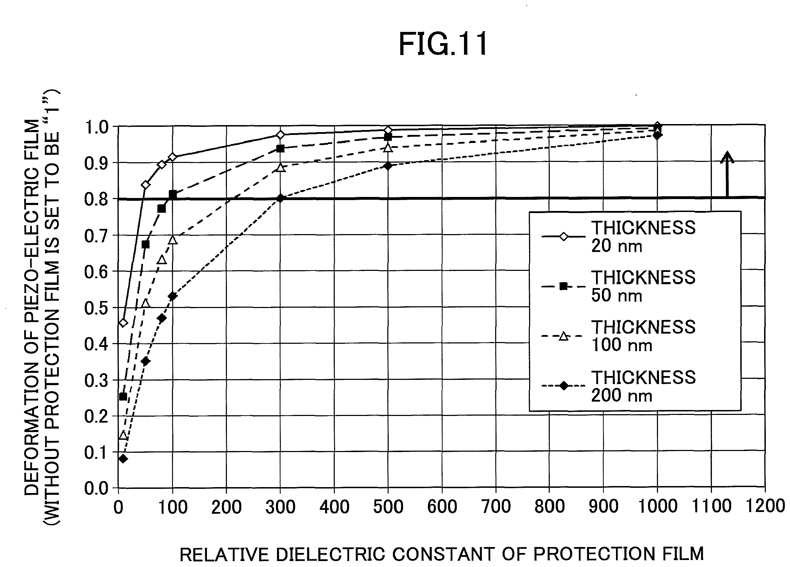

From a viewpoint of deformation of the piezo-electric film 33, a relationship between the thickness and the relative dielectric constant of the protection film 37 is important. A studied result for this relationship is illustrated in Fig. 11. In Fig. 11, an axis of ordinates indicates a relative value of deformation of the piezo-electric film 33 when deformation of the piezo-electric film 33 in a case where the protection film 37 does not exist is "1". It is preferable that the relative value of the deformation of the piezo-electric film 33 is greater than or equal to 0.8. In other words, it is preferable to select the protection film 37 having the thickness and the relative dielectric constant that is plotted at an upper side of a line of 0.8 of Fig. 11. As the protection film 37, for example, TiO₂ with a thickness of 50 nm and with a relative dielectric constant of 85 may be used.

As such, the protection film 37 is formed on the upper surface of the piezo-electric film 33 in this embodiment. This is for improving dielectric voltage of the piezo-electric film 33. In other words, as described in the first embodiment, if irregularity (concavo-convex portion) exists at the upper surface of the piezo-electric film 33, an electrode material that constitutes the upper electrode 34 cannot enter a space between the concavo-convex portions, and fine concave portions or voids are formed. In such a case, stress that is generated when the piezo-electric film is deformed (when voltage is applied) concentrates on a front end of the concave portion, crack is generated at the front end of the concave portion, and breakdown occurs when the crack is expanded.

Thus, in this embodiment, the protection film 37 whose embedding property to the concavo-convex portions at the surface is higher than that of the upper electrode 34 is formed on the upper surface of the piezo-electric film 33. With this, the protection film 37 is embedded in the concavo-convex portions of the upper surface of the piezo-electric film 33, and an upper surface of the protection film 37 is a more flat surface than the upper surface of the piezo-electric film 33. This means that although the planarization process is performed by the etching process on the upper surface of the piezo-electric film 33 in the first embodiment, according to the present embodiment, the planarization process is performed by forming the protection film 37, and the upper surface of the protection film 37 is the surface on which the planarization process is performed.

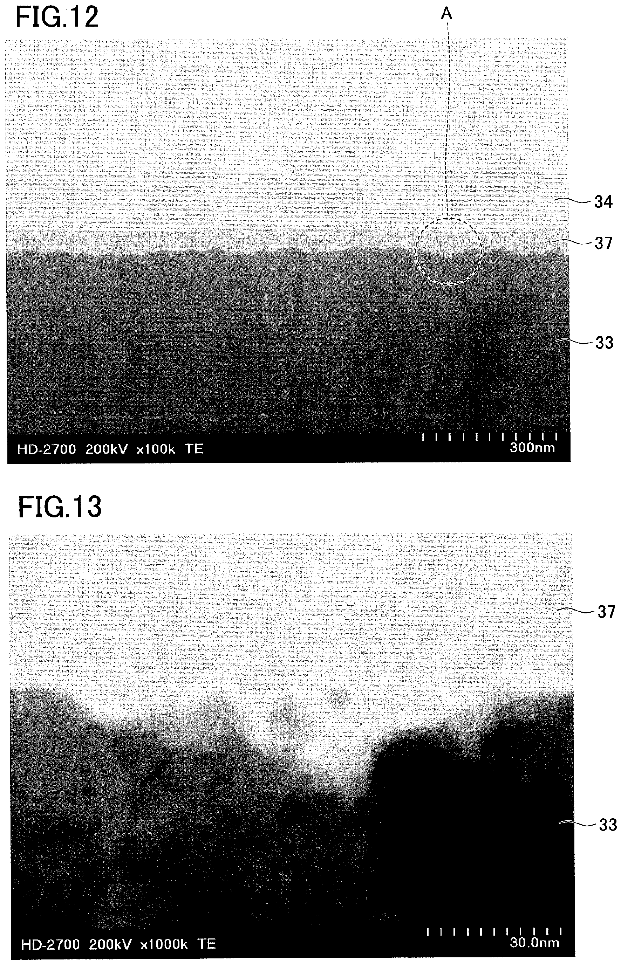

Fig. 12 and Fig. 13 are cross-sectional images of a piezo-electric film on which a protection film is deposited, and Fig. 13 is an enlarged view of a portion "A" of Fig. 12. Here, PZT was used as the piezo-electric film 33, and TiO₂ with a thickness of 50 nm and with a relative dielectric constant of 85 was used as the protection film 37. As illustrated in Fig. 12 and Fig. 13, it can be confirmed that the protection film 37 is embedded in the concavo-convex portions of the upper surface of the piezo-electric film 33 without gaps, and the upper surface of the protection film 37 is a more flat surface than the upper surface of the piezo-electric film 33.

**[Table 3]**

| | | SURFACE ROUGHNESS Ra (nm) |
|---|---|---|
| PROTECTION FILM | WITHOUT | 4.19 |
| | WITH | 2.2 |
| | WITH/WITHOUT | 0.53 |

Table 3 illustrates surface roughness Ra calculated from images of Fig. 12 and Fig. 13. From Table 3, it can be understood that the surface roughness (Ra = 2.20) of the upper surface of the protection film 37 is approximately half compared with the surface roughness (Ra = 4.19) of the upper surface of the piezo-electric film 33.

**[Table 4]**

| | | SURFACE ROUGHNESS Ra (nm) |
|---|---|---|
| PLANARIZATION PROCESS | WITHOUT | 2.32 |
| | WITH | 1.13 |
| | WITH/WITHOUT | 0.49 |

Table 4 illustrates, for comparison, a result obtained by measuring the surface roughness Ra by an atomic force microscope (AFM) for a case in which the planarization process is performed by GCIB. From Table 4, it can be understood that the surface roughness (Ra = 1.13) of the upper surface of the piezo-electric film 33 when the planarization process was performed is approximately half of the surface roughness (Ra = 2.32) of the upper surface of the piezo-electric film 33 when the planarization process was not performed.

Basically, the surface roughness Ra without the protection film of Table 3 and the surface roughness Ra without the planarization process of Table 4 should be the same. However, the measurement results are different for approximately 2 times. This can be considered as a difference in measurement methods. The values of Table 3 should be about halves (can be converted to be half values), respectively, when being measured by the atomic force microscope (AFM).

Thus, in this application, the surface roughness of a surface that contacts the upper electrode 34 in the piezo-electric element is defined by a value measured by an atomic force microscope (AFM) (the value calculated from the image is converted to a value measured by the atomic force microscope (AFM)).

This means that in order to improve dielectric voltage of the piezo-electric film 33, regardless of the existence of the protection film 37, it is desirable that the surface roughness (measured area: 10µm□) of a surface that contacts the upper electrode 34 of the piezo-electric element is less than or equal to 1.3 nm by a measurement by an atomic force microscope (AFM), more desirably, less than or equal to 1.0 nm.

### (Study of dielectric voltage)

Samples with and without the protection film 37 were manufactured, and dielectric voltage was studied. Here, PZT with a thickness of 2.0 µm was used as the piezo-electric film 33, and TiO₂ with a thickness of 50 nm and with a relative dielectric constant of 85 was used as the protection film 37. Further, the electrode diameter of each of the lower electrode 32 and the upper electrode 34 was 1 mmϕ.

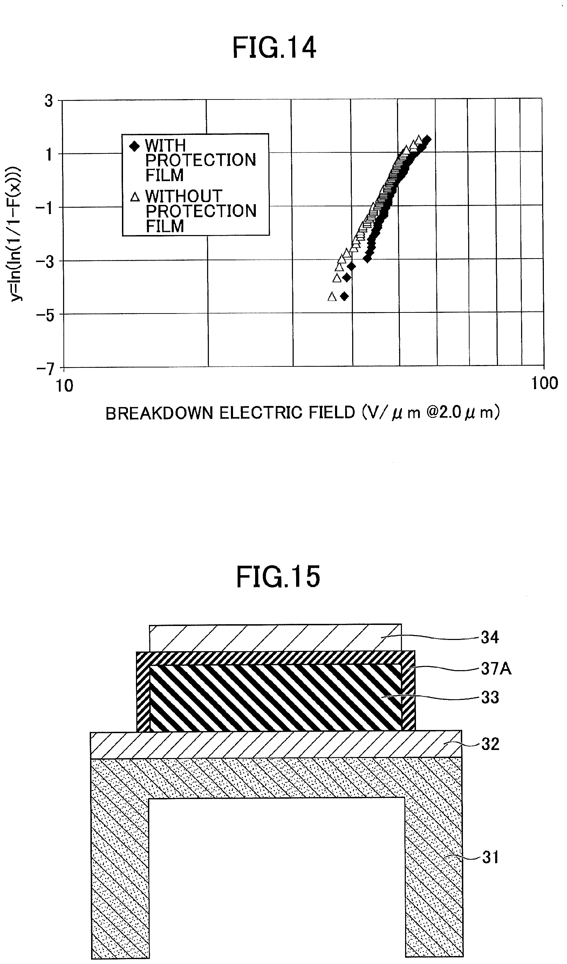

Next, direct-current voltage was applied between the lower electrode 32 and the upper electrode 34 of each of the manufactured samples, and dielectric voltage was measured. Weibull distribution of the breakdown electric field is illustrated in Fig. 14.

As illustrated in Fig. 14, the case of with the protection film is more shifted in a rightward direction, and dielectric voltage is improved. Although designed drive voltage is approximately 20 V, it is preferable that Weibull distribution of Fig. 14 is shifted rightward because margin of dielectric voltage can be largely retained. Here, an average value of breakdown electric field with the protection film was 48.72 V / µm and an average value of breakdown electric field without the protection film was 46.47 V / µm.

As such, in the second embodiment, the protection film 37 is formed on the upper surface of the piezo-electric film 33, and the surface roughness of the surface that contacts the upper electrode 34 is reduced. With this, a starting point on which stress is concentrated when the piezo-electric film 33 is deformed can be removed, and dielectric voltage of the piezo-electric film 33 can be improved.

Here, as a protection film 37A illustrated in Fig. 15, a protection film may be formed to cover the upper surface and side surfaces of the piezo-electric film 33. In such a case as well, merits same as those of the structure of Fig. 10 can be obtained.

Further, the planarization process by etching as described in the first embodiment may be performed on the upper surface of the piezo-electric film 33, and thereafter, the protection film 37 may be further formed.

Although preferred embodiments have been specifically illustrated and described, it is to be understood that minor modifications may be made therein without departing from the spirit and scope of the invention as defined by the claims.

For example, an example in which the piezo-electric actuator including the piezo-electric element of the invention is used for the optical scanner control apparatus is described, and the laser scanning projector is exemplified as the optical scanner control apparatus in the above described embodiments. However, the optical scanner control apparatus may be, for example, an on-vehicle head up display, a head mount display, a laser printer, a laser scanning epilator, a laser head lamp, a laser radar or the like.

Further, the piezo-electric actuator including the piezo-electric element of the invention may be used for an optical scanner, an ink-jet recording head, a gyro sensor, an electrostatic sensor, an energy harvester, a supersonic sensor, an RF MEMS switch, an activating switch for a wireless sensor terminal or the like.

The present application is based on and claims the benefit of priority of Japanese Priority Application No. 2015-186565 filed on September 24, 2015, the entire contents of which are hereby incorporated by reference.
- 1: optical scanner control apparatus
- 10: circuit unit
- 11: system controller
- 12: CPU
- 13: buffer circuit
- 14: mirror driving circuit
- 15: laser driving circuit
- 16: temperature control circuit
- 20: light source unit
- 21: LD module
- 22: temperature control unit
- 23: temperature sensor
- 24: beam attenuating filter
- 30: optical scanner apparatus
- 31: substrate
- 32: lower electrode
- 33: piezo-electric film
- 34: upper electrode
- 37,: 37A protection film
- 40: optical unit
- 50: screen
- 60: light quantity detection sensor
- 211R, 211G, 211B: laser
- 215: light quantity detection sensor
- 310: mirror
- 320: mirror support portion
- 322: slit
- 330A, 330B: torsion beam
- 340A,: 340B connecting beam
- 350A, 350B, 370A, 370B: driving beam
- 351A, 351B, 371R, 371L: driving source
- 360: movable frame
- 380: fixed frame
- 391: horizontal displacement sensor
- 392, 393, 394: dummy sensor
- 395, 396: vertical displacement sensor

## Claims

1. A piezo-electric element, comprising:
a substrate;
a lower electrode formed on the substrate;
a piezo-electric film formed on the lower electrode; and
an upper electrode formed on the piezo-electric film,
wherein the upper electrode is formed on a surface on which a planarization process is performed.

2. The piezo-electric element according to claim 1, wherein the surface on which the planarization process is performed is an upper surface of the piezo-electric film.

3. The piezo-electric element according to claim 1, wherein the surface on which the planarization process is performed is a surface of a protection film that is formed between the piezo-electric film and the upper electrode.

4. A piezo-electric actuator comprising the piezo-electric element of claim 1.

5. A method of manufacturing a piezo-electric element, comprising:
forming a lower electrode on a substrate;
forming a piezo-electric film on the lower electrode;
performing a planarization process on the piezo-electric film; and
forming an upper electrode on a surface that is formed by the performing the planarization process.

6. The method of manufacturing the piezo-electric element according to claim 5, wherein in the performing the planarization process on the piezo-electric film, etching is performed on an upper surface of the piezo-electric film and the upper surface of the piezo-electric film is made to be the surface on which the planarization process is performed.

7. The method of manufacturing the piezo-electric element according to claim 6, wherein the etching is performed by a gas cluster ion beam.

8. The method of manufacturing the piezo-electric element according to claim 5, wherein in the performing the planarization process on the piezo-electric film, a protection film is formed on an upper surface of the piezo-electric film.

9. The method of manufacturing the piezo-electric element according to claim 5, wherein in the performing the planarization process on the piezo-electric film, a protection film is formed on an upper surface of the piezo-electric film after performing etching on the upper surface of the piezo-electric film.

10. The method of manufacturing the piezo-electric element according to claim 8, wherein the protection film is formed by an Atomic Layer Deposition method.

## Amended claims

### Amended claims under Art. 19.1 PCT

**1.** A piezo-electric element, comprising:
a substrate;
a lower electrode formed on the substrate;
a piezo-electric film formed on the lower electrode; and
an upper electrode formed on the piezo-electric film,
wherein the upper electrode is formed on a surface on which a planarization process is performed.

**2.** The piezo-electric element according to claim 1, wherein the surface on which the planarization process is performed is an upper surface of the piezo-electric film.

**3.** The piezo-electric element according to claim 1, wherein the surface on which the planarization process is performed is a surface of a protection film that is formed between the piezo-electric film and the upper electrode.

**4.** Added) The piezo-electric element according to claim 1, wherein an average roughness Ra of an upper surface of the piezo-electric film is less than or equal to 1.3 nm.

**5.** Added) The piezo-electric element according to claim 1, wherein an average roughness Ra of an upper surface of the piezo-electric film is less than or equal to 1.0 nm.

**6.** Added) The piezo-electric element according to claim 1, wherein the piezo-electric film is a driving source of an actuator that oscillates a mirror in a horizontal direction, and a driving source of an actuator that oscillates the mirror in a vertical direction.

**7.** (Amended) A piezo-electric actuator comprising the piezo-electric element of claim 1.

**8.** (Amended) A method of manufacturing a piezo-electric element, comprising:
forming a lower electrode on a substrate;
forming a piezo-electric film on the lower electrode;
performing a planarization process on the piezo-electric film; and
forming an upper electrode on a surface that is formed by the performing the planarization process.

**9.** (Amended) The method of manufacturing the piezo-electric element according to claim 8, wherein in the performing the planarization process on the piezo-electric film, etching is performed on an upper surface of the piezo-electric film and the upper surface of the piezo-electric film is made to be the surface on which the planarization process is performed.

**10.** (Amended) The method of manufacturing the piezo-electric element according to claim 9, wherein the etching is performed by a gas cluster ion beam.

**11.** (Amended) The method of manufacturing the piezo-electric element according to claim 8, wherein in the performing the planarization process on the piezo-electric film, a protection film is formed on an upper surface of the piezo-electric film.

**12.** (Amended) The method of manufacturing the piezo-electric element according to claim 8, wherein in the performing the planarization process on the piezo-electric film, a protection film is formed on an upper surface of the piezo-electric film after performing etching on the upper surface of the piezo-electric film.

**13.** (Amended) The method of manufacturing the piezo-electric element according to claim 11, wherein the protection film is formed by an Atomic Layer Deposition method.
